Europäisches Patentamt

European Patent Office

Office européen des brevets

(19)

(11) Publication number: **0 060 101**
B1

(12) # EUROPEAN PATENT SPECIFICATION

(45) Date of publication of patent specification: 07.09.88

(51) Int. Cl.⁴: **H 04 N 1/41,** G 09 G 1/16,
H 03 K 21/00

(21) Application number: 82301125.9

(22) Date of filing: 05.03.82

(54) **Image data conversion and character code/character pattern conversion.**

(30) Priority: 06.03.81 JP 32126/81
11.03.81 JP 35034/81

(43) Date of publication of application:
15.09.82 Bulletin 82/37

(45) Publication of the grant of the patent:
07.09.88 Bulletin 88/36

(84) Designated Contracting States:
DE FR GB

(56) References cited:
DE-A-2 731 955
US-A-3 828 319
US-A-3 911 420

ELECTRONIC ENGINEERING, vol. 51, no. 622,
May 1979, page 35, London, GB; G.W.
HAYWOOD: "Multiple counters using RAMs"

IEEE-ICC 79 Conference Record, vol. 1-4, 10-14
Juni 1979, pp. 8.7.1-3.7.5 (79CH1435-7CSCB)

(73) Proprietor: FUJITSU LIMITED
1015, Kamikodanaka Nakahara-ku
Kawasaki-shi Kanagawa 211 (JP)

(72) Inventor: Abe, Susumu
30, Shimokodanaka Nakahara-ku
Kawasaki-shi Kanagawa 211 (JP)
Inventor: Munakata, Akio
23-23 Kaminoge 3-chome
Setagaya-ku Tokyo 158 (JP)
Inventor: Kitahara, Takeshi
15-8, Higashigotanda 1-chome
Shinagawa-ku Tokyo 141 (JP)

(74) Representative: Sunderland, James Harry et al
HASELTINE LAKE & CO Hazlitt House 28
Southampton Buildings Chancery Lane
London WC2A 1AT (GB)

EP 0 060 101 B1

Courier Press, Leamington Spa, England.

**Description**

This invention relates to image data conversion and character code/character pattern conversion.

In image processing apparatus, for example facsimile equipment, the number of picture elements of a line of a draft (an image) of size A4 (corresponding to one scanning line of a CRT cathode ray tube, not to a line on a printed page) is taken to be 1728 bits, or 2432 bits for the size A3. In the case of facsimile equipment the amount of data to be transmitted is reduced; a photo-electric conversion output is not transmitted directly but in general band compression is carried out before transmission. Further, when transmitting a code output of a computer to facsimile equipment, band compression is required in the same way to replace character patterns provided by the computer.

If access is made to a character generator (CG) with a code signal transmitted from a computer and a character pattern signal of 5×7 or 16×16 dots/character is output and is subject to band compression for transmission to facsimile equipment characters are all fixed at a small size since the dot interval is small and constant. However, it is actually desirable to enable a title to appear in large size characters which can be read easily and to enable other contents, or comments, to appear in small size characters. Therefore, it is desirable to be able to carry out character expansion and reduction processes for the output of a character generator.

In the case of ordinary facsimile equipment, the bit information giving image data or pictures to be transmitted is converted to an intermediate code, for example into runlength code, in order to compress the bit information to be transmitted. This runlength code expresses consecutive occurrences of the same code bit value with information indicating the code bit value and the number of consecutive occurrences, that is, the length of a sequence of bits of that one code bit value. For example, the bit train "001111000" is converted into runlength code in such a way that 0 is indicated to have a 2-bit length or runlength (e.g. there is a run of two 0 bits), then 1 is indicated to have a 4-bit runlength and then 0 is indicated to have a 3-bit length.

In an existing conversion system for converting image data into runlength code, image bit information is converted into serial bits by a parallel-serial converter and the number of bits appearing during a period between one change point (at which bit value changes from 0 to 1 or from 1 to 0) to the next change point is measured by means of a counter. This method has a disadvantage in that conversion processing requires a relatively long time because the serial bits must be checked bit by bit and when the time required for the parallel-serial converter to output one bit is taken to be t, a time n×t is necessary for converting the bit information of image bits in a n-bit form into bit length information.

To improve upon the conversion time of such a system, it is possible, for example, to employ a system in which a code conversion table is prepared and input image data is converted to runlength code by access to that table. Using such a conversion table a problem arises in that although conversion time can be improved considerably, because it is determined only by the retrieval time of the conversion table, table size becomes large in a case in which the image data length in a unit of data to be converted (such as facsimile data) is comparatively long.

For this reason it is desirable to provide a conversion system which overcomes the disadvantages of the existing bit serial conversion system and of a system using such a code conversion table.

IEEE-ICC'79 Conference Record, Volume 1 of 4, 10—14 June 1979, pages 8.7.1 to 8.7.5, concerns a two-dimensional facsimile coding scheme in which account is taken of vertical correlation between scanning lines. Locations of transitions (colour changes) on one line are correlated with the locations of such changes on the next line. Periodically, a one-dimensionally coded line is sent. The standard recommended, the Huffman Code, codes into runlengths. Code tables, containing code words for runs of lengths 1 to 63, have been constructed.

US—A—3 828 319 discloses the use of runlength coding for facsimile image data.

DE—A1—27 31 955 concerns character generation, for characters to be displayed on a raster scanning output device. The use of runlength coding is mentioned.

According to the present invention there is provided a method of data conversion, comprising:

reading, from a runlength conversion table, successive runlength codes corresponding to a data signal;

and characterised by

holding a last runlength code, or an added runlength code as explained below, temporarily in a register;

detecting, as between the last runlength code and a next runlength code, whether those codes relate to runlengths of bits of the same value (1 or 0);

adding the runlength code held in the register to the said next runlength code, and placing the resulting added runlength code in the register, when it is detected that the last and next codes relate to runlengths of bits of the same value.

Reference is made, by way of example, to the accompanying drawings, in which:—

Figure 1 is a schematic block diagram of a runlength code conversion circuit of an embodiment of the present invention,

Figure 2 is a time chart for assistance in explaining operation of the circuit of Figure 1,

Figure 3 is a schematic diagram illustrating input-output relationships for a conversion table employed in the embodiment of Figure 1,

Figure 4 is a more detailed diagram of the conversion circuit of Figure 1,

Figures 5(a) and 5(b) are diagrams for assistance in explanation of character enlarging procedures,

Figure 6 is a block circuit diagram of a character code/character pattern conversion apparatus embodying the present invention,

Figure 7(a), 8 and 9 are block diagrams showing in more detail parts of the apparatus of Figure 6,

Figure 7(b) to 7(d) are schematic diagrams for assistance in explanation of operation of the apparatus of Figure 6,

Figure 10 is a flow chart for assistance in explaining character enlargement operation of the apparatus of Figure 6, and

Figure 11 is a block diagram of facsimile communication equipment employing a circuit as shown in Figure 6.

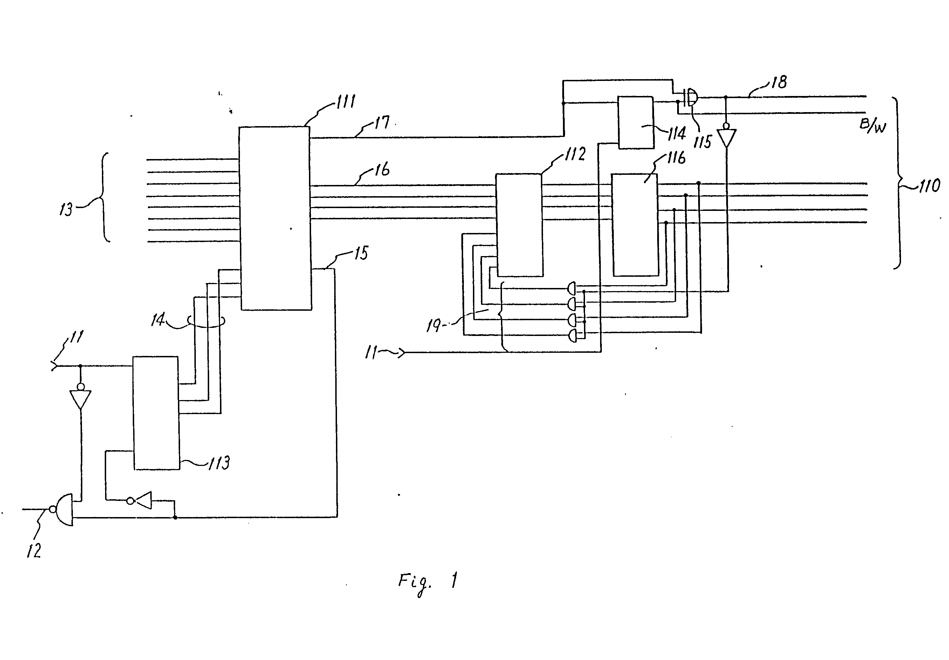

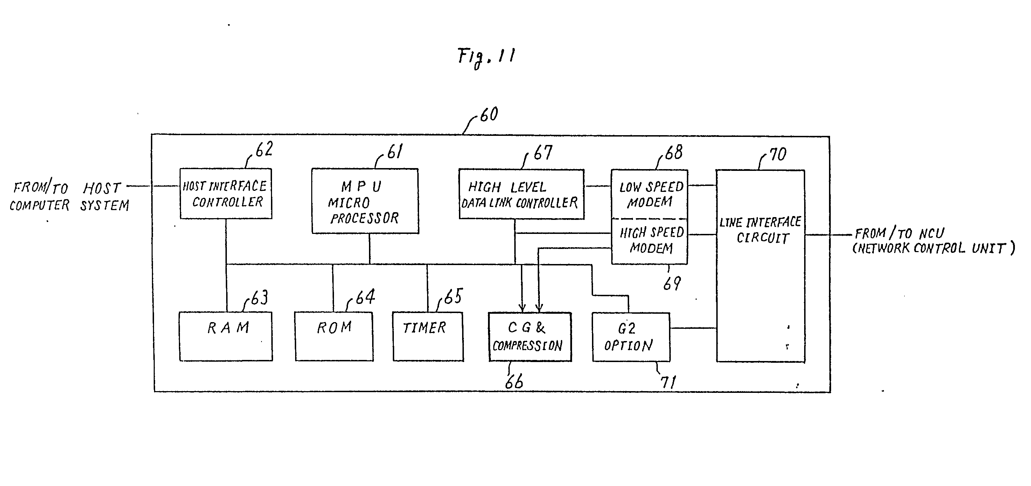

In Figure 1, 11 is a conversion clock signal line; 12 is a bit train update signal line; 13 is an input bit signal line, for a signal to be converted; 14 is a conversion cycle signal line; 15 is a conversion end flag signal line; 16 is a partial bit length signal line; 17 is a code output signal line indicating whether the bit length signal on line 16 corresponds to a run of bits of value 0 or a run of bits of value 1; 18 is a code output change detection signal line; 19 is an added value signal line; 110 is a conversion result output line; 111 is a conversion table; 112 is an adder; 113 is a counter; 114 is a D-type flip-flop; 115 is an exclusive OR gate; and 116 is a register.

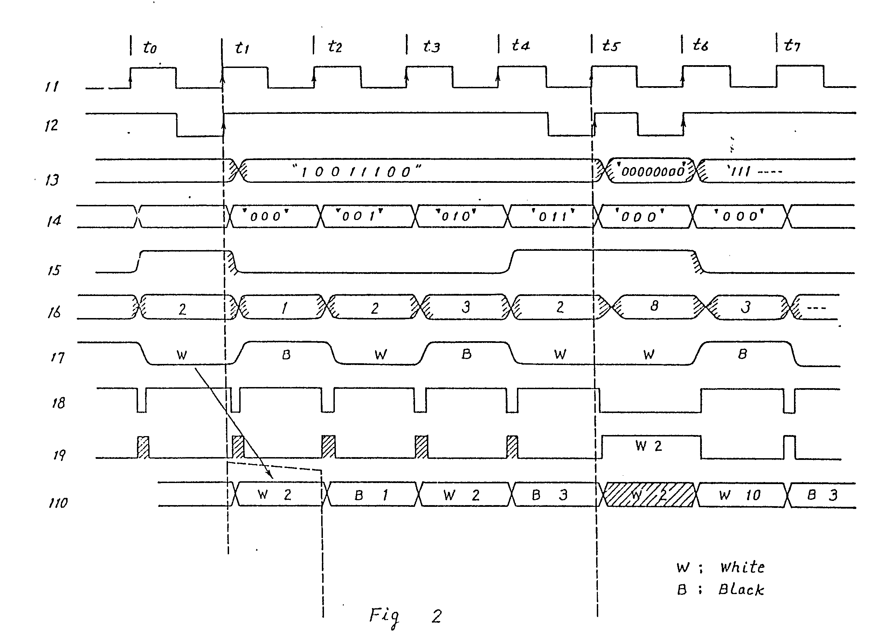

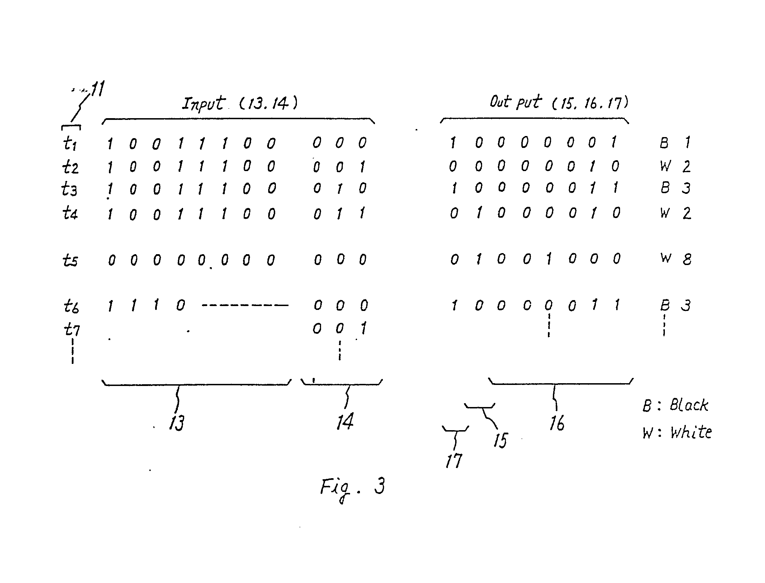

In Figure 2 and in Figure 3, items relating to portions as shown in Figure 1 are given the same reference numerals as those portions. Thus, signal waveforms in the time chart of Figure 2, and logical conditions in the diagram of Figure 3, are given the reference numbers of corresponding signal lines in Figure 1.

It will be assumed that the following bit train is to be converted.

$$...100\triangle10011100\triangle00000000\triangle1110$$

A triangle $\triangle$ indicates a location at which the bit train is partitioned into partial trains (split bit trains). In this example of an embodiment of the present invention input data is split after every eighth bit for conversion.

The clock signal on the conversion clock signal line 11 is input to the counter 113, which generates conversion cycle signals on the conversion cycle signal (counter value) line 14. These conversion cycle signals are counter values which are counted as the counter is clocked. Input data on the input bit signal line 13 is applied to the conversion table 111 together with a conversion cycle signal and a conversion output is read out from the conversion table 111. The signal on line 15 is a conversion end flag signal, the signal on the line 16 is a partial bit length signal which indicates the length (e.g. number of bits) for which the same code value (1 or 0) appears consecutively in the divided (split) input data, the signal on the line 17 is a code output signal indicating whether the partial bit length signal relates to a code value 1 or to a code value 0 (black or white in terms of image data). The signal on the bit train update signal line 12 used for updating the bit train on the input bit signal line 13 provides the split bit train to be converted next, by detecting the conversion end flag signal (e.g. in this case, each update signal causes a next split train of eight bits to be delivered). The signal on the code output change detecting signal line 18 is used for detecting a change in the signal on the code output signal line 17 and is provided as an output of code output change detecting means which are composed of D-type flip-flop 114, which receives input data from the code output signal line 17 and a clock input from the conversion clock signal line 11, and the exclusive OR gate 115.

Namely, when the code output (on signal line 17 and indicating a code value 1 or 0) existing prior to one particular conversion clock signal (at the end of one split train) and the code output existing in the next conversion clock signal period (following the particular conversion clock signal—at the beginning of the next split train) match one another, an output on signal line 18 becomes 0 as shown in $t_5$ of Figure 3.

When the code change detecting signal on line 18 is 0, the content of a partial bit length output signal relating to the period just before the particular conversion clock signal in question (to the end of one split train), being stored in the register 116, is input as an adder value signal to the adder 112 and it is added to the partial bit length output signal relating to the period following the particular conversion clock signal (the beginning of the next split train). Thereby, an added partial bit length output can be obtained.

Namely, addition control in dependence upon the signal on the code output change detecting signal line 18 is carried out for adding partial bit length output signals, conversion outputs of conversion table 111, for obtaining a larger bit length value in a case in which no code change occurs between the split bit train (in a case in which both before and after the split white or black code values are obtained; i.e. when one code value is found on both sides of the split).

Each circuit of Figure 1 changes status (if appropriate) as the rising portion of a clock signal on the conversion clock signal line 11. The signal on the bit train update signal line 12 is formed so that the bit train (on the input signal line) is updated at the rising portion of the signal on line 12 (i.e. the next split train is then delivered).

In practice, when a memory address is updated by the signal on the bit train update signal line 12 and then output of the memory is taken to be the input bit signal to be converted, memory access time is required to elapse before the input bit signal to be converted is stabilized after rising of the memory output.

In response to an address input to conversion table 111, the conversion end flag signal (line 15), partial bit length signal (line 16) and the code output signal (line 17), which indicates whether the partial bit length signal relates to a code value 1 or a code value 0 in a bit train, are output but a considerable time is required to elapse before the code output signal (line 17) is stabilized after rise of a clock signal on the conversion table 111 because the conversion table 111 provides a delay time since it is a memory. As a result, the code output change detection signal (line 18) and added value signal (line 19) change meaninglessly for a time and are considered as invalid during that time (refer to the hatched areas of Figure 2).

Operations will now be described with reference to Figure 1 and Figure 2.

For inputs as illustrated in Figure 2, the conversion table output (lines 15, 16, 17) from the time $t_1$ initially becomes black 1 (the code output signal line 17 indicates black by carrying a code value 1, whilst the partial bit length signal ine 16 indicates the length of black, that is, the number of consecutive occurrences of bits having a black value 1 in input data, by carrying a bit length of 1). The length on the partial bit length signal line is input to the adder 112. The inputs to the conversion table are the input bit signal shown at 13 in Figure 2 (10011100) at the relevant time, and the conversion cycle signal shown at 14 in Figure 2 (which is initially 000). The signal on the added value signal line 19 is not input to the adder 112 if the code output signal line 17 shows a change in code output (i.e. a change from black to white or white to black) over a particular clock signal (e.g. the clock signal occurring at the beginning of $t_1$ in this case). Therefore, in this case no addition takes place and the information black 1 is stored in the register 116 at the rising portion of the conversion clock (line 11) at the beginning of time $t_2$ and then output on the conversion result output line 110. When the conversion clock rises at the beginning of $t_2$, the conversion end flag (line 15) indicates that conversion is to be continued (i.e. has not ended) by carrying a 0. As a result, the counter 113 counts up and the conversion cycle signal (line 14) indicating the conversion cycle is updated (to give a next conversion cycle signal 001).

In this way conversion continues up to time $t_4$, at which time the conversion end flag (line 15) indicates the end of conversion by carrying a 1. Therefore, the counter 113 is initialized (ALL 0) and a bit update pulse for the bit train update signal (line 12) is transmitted.

In this case, added value signal (line 19) immediately after time $t_5$, and the code output signal (white) from conversion table 111 immediately after time $t_5$ match (both are white code values). The white 2 code value which is the result of conversion at time $t_4$ is input to the adder 112 and it is this which is provided as the added value signal which is then added to the conversion table output at time $t_5$. The result of addition is output on conversion result output line 110 at time $t_6$.

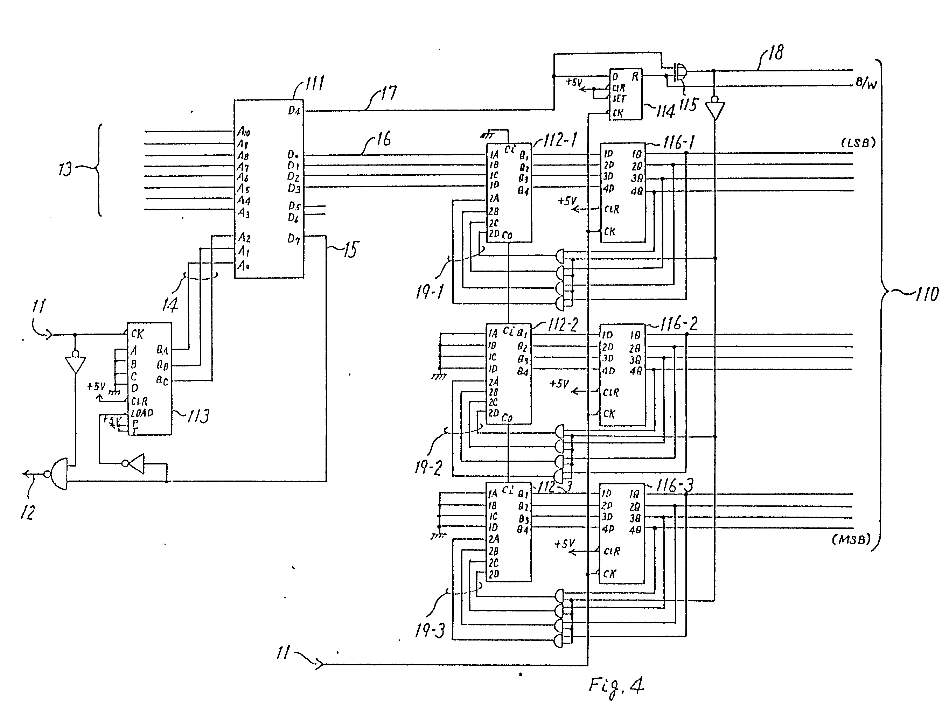

With regard to the detailed diagram of Figure 4, similar items in Figures 1 and 4 are in general given the same reference numbers. In Figure 4, 112-1 to 112-3 correspond to adder 112 in Figure 1, 116-1 to 116-3 correspond to register 116 in Figure 1, and 19-1 to 19-3 correspond to the added value signal line 19 in Figure 1.

The image data conversion method explained with reference to Figures 1 to 4 requires a clock cycle which is the same as that of previously proposed systems for conversion of a pattern in which 1 and 0 appear alternately in the bit information, but significant improvement can be obtained, such that conversion can be affected at high speed with a lesser number of clocks (about a half of the previously proposed system in this example) as compared with the previously proposed systems, in a case in which 1 or 0 occurs several times consecutively, in input bit information describing a pattern.

In the method described with reference to Figures 1 to 4, an input bit train is converted by the conversion table after the train has been divided or split and as a result a large conversion table is not required. This is a notable advantage.

Character code/character pattern conversion apparatus will now be explained.

Since the number of picture elements on a line of a facsimile picture is fixed at 1728 bits (where the picture is of size A4) or 2432 bits (where the picture is of size A3) characters, even enlarged characters, and character intervals on the line must conform to these numbers of bits (picture elements) without leaving any vacant areas. Therefore, when a basic number of bits corresponding to one character of basic size is taken to be A (the unit bit size of a character), a character enlargement coefficient is taken to be N, the number of characters on a line is taken to be M and a character interval to be B, these parameters must be determined so that the following equations are satisfied.

$$\text{Size A4: } 1728=(A\times N+B)\times M, \text{ where } A\times N\geq B$$

$$\text{Size A3: } 2432=(A\times N+B)\times M, \text{ where } A\times N\geq B$$

(Where, A, N, B, M are integers).

Here, a line starts with a character and the last character on the line is followed by a character interval B. Permissible combinations of values of parameters M, N, B when the unit bit size of a character (A) is 16 are shown in Table 1.

4

TABLE 1

| Size A4 | | | Size A3 | | |
|---|---|---|---|---|---|
| M | N | B | M | N | B |
| 108 | 1 | 0 | 152 | 1 | 0 |
| 96 | 1 | 2 | 128 | 1 | 3 |
| 72 | 1 | 8 | 76 | 1 | 16 |
| 64 | 1 | 11 | | 2 | 0 |
| 54 | 1 | 16 | 64 | 2 | 6 |
| | 2 | 0 | 38 | 2 | 32 |
| 48 | 2 | 4 | | 3 | 16 |
| 36 | 2 | 16 | | 4 | 0 |
| | 3 | 0 | 32 | 3 | 28 |
| ⋮ | ⋮ | ⋮ | | 4 | 12 |
| ⋮ | ⋮ | ⋮ | ⋮ | ⋮ | ⋮ |

As will be appreciated from Table 1 above, the number of characters on a line, the character size and character interval must be such that character size plus character interval is a divisor of the number of picture elements on the line. Thus, a desired size of character and a desired character interval cannot be selected at will.

This invention overcomes this problem by a method as explained below and makes it possible to select for each individual line a desired size of character and a desired character interval.

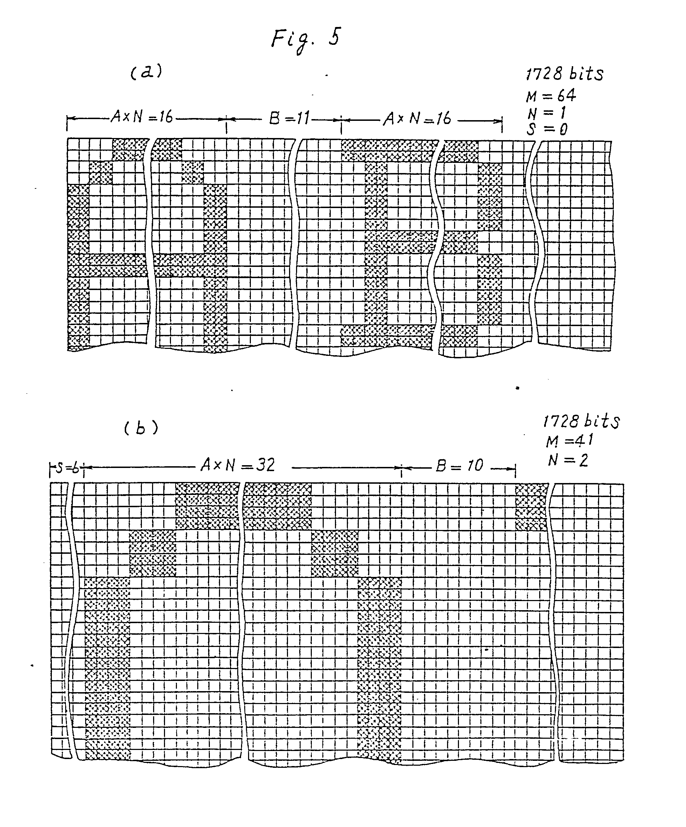

As shown in Figure 5(a), when a unit bit size of one character is A=16, the character interval is B=11, and the character enlargement coefficient N=1, the relationship $1728=(A \times N+B) \times M$, $A \times N \geq B$ (A, N, B, M being integers) can be satisfied. However, as shown in Figure 5(b), when A=16, N=2, B=10, the relationship cannot be satisfied; character size ($16 \times 2$) plus character interval (10) equals 42, which divides 1728 with a remainder S=6. Only if allowance is made for this remainder can the required number of bits for a line be provided and a desired character size and a desired character interval be selected. This can be achieved if a number of bits corresponding to the remainder are placed between the line starting edge and the first character on the line.

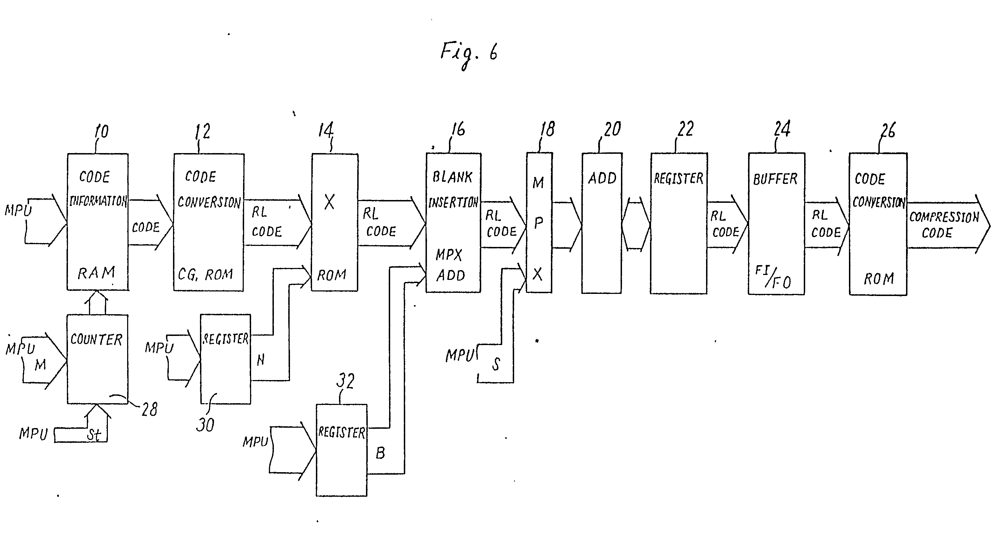

Figure 6 is a block circuit diagram of a circuit in which control is effected by an MPU (microprocessor unit). 10 is a (code memory) circuit for storing code information. In this embodiment of the present invention the circuit 10 is made up of RAM (random access memory) into which a desired character code can be written from MPU. 28 is the code memory (10) control counter operative to change the memory 10 between write and read modes and to control the number of characters written or read. For example, when a number of characters M=41 is provided by operation of the MPU in accordance with the equation above and Figure 5(b), the MPU sets the number of characters 41 into the counter 28 and moreover writes the required character codes, 41 at maximum, into the memory 10. When a start signal $S_t$ is input from the MPU under these conditions, the counter 28 executes processing, for example sequentially reading character codes from the memory 10. 30, 32 are registers, into which the character enlargement coefficient N and character interval B are respectively set by the MPU.

12 is a code converter providing a character generator CG and ROM (read only memory), which converts input character code signals to an image (character pattern) signal and further converts such image signal into run-length codes.

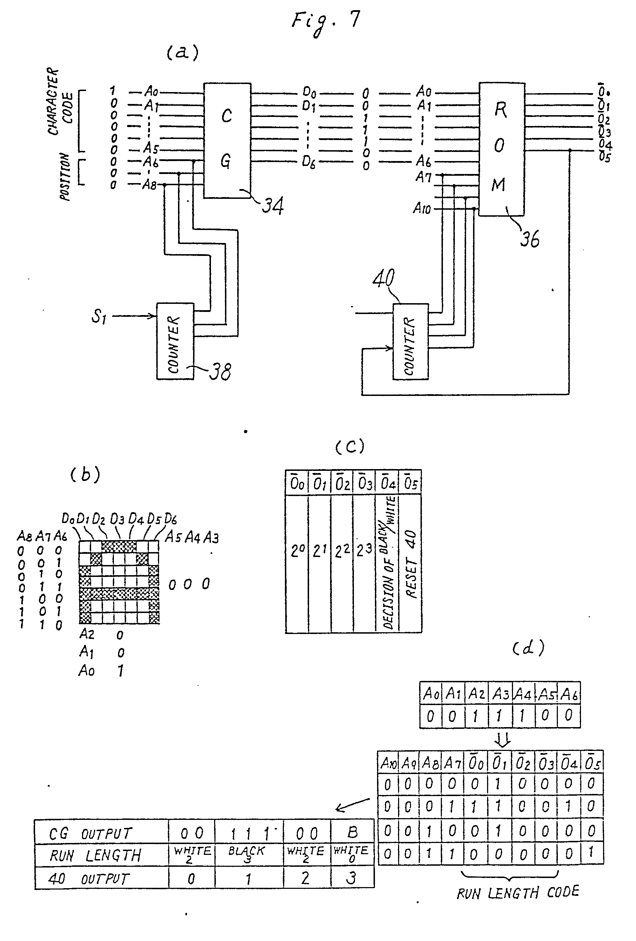

Detailed explanation of code converter 12 will be given with reference to Figures 7(a) to 7(d). In Figure 7(a), 34 and 36 are the character generator CG and ROM mentioned above and 38 and 40 are counters which are operable to output part address signals for making access to CG and ROM. When character codes $A_0$ to $A_5$, input from the code memory 10, are "100000", corresponding to a character "A", these codes are input CG 34 as a part of an address signal therefor and a 3-bit output of the counter 38 is input to CG 34 as the remaining part of the address signal. The former address signal part ($A_0$ to $A_5$) designates the character

and the latter address signal part designates a particular line of the character and pattern signals (image data) $D_0$ to $D_6$ relating to the pertinent line of the character are output.

The image data $D_0$ to $D_6$ is 0011100 for the first line ($A_6$, $A_7$, $A_8=0$) of character A, 0100010 for the second line ($A_6=1$, $A_7$, $A_8=0$) and 1000001 for the third line ($A_6=A_8=0$, $A_7=1$) as shown in Figure 7(b).

When image data relating to one line is obtained, a clock signal $S_1$ is input to the counter 38 and thereby the counter value held in the counter is incremented by +1 and image data corresponding to the next line is output. In this example, 3-bits in the former and latter halves of the character codes $A_0$ to $A_5$ designate rows and columns of character pattern groups arranged in the form of matrices.

Herein, a character pattern is taken to comprise 7×7 dots and a character actually using as little as 8×8=64 dots can be used. In practice, however, character patterns of a total of 16×16 dots as explained above are used and a considerable number of characters are used.

Image data $D_0$ to $D_6$ sent from character generator CG in combination with the 4-bit output of the counter 40 becomes an address signal for ROM 36, and the ROM 36, which is to be accessed by the address signal, sequentially outputs runlength codes (each $\overline{0}_0$ to $\overline{0}_5$). For example, in a case in which the image data $D_0$ to $D_6$ is 0011100, runlength codes white 2, black 3, white 2, white 0 are sequentially output. The last white 0 corresponds to the character interval and is applied to all CG outputs. The counter 40 is reset at the timing following the output of the last white 0 and gets ready for runlength code conversion in respect of next image data. $S_2$ is a clock signal for incrementing the counter 40 by +1.

This will be explained further by reference to Figure 7(c). As indicated in the figure, $\overline{0}_0$, $\overline{0}_1$, $\overline{0}_2$, $\overline{0}_3$ of a runlength code corresponding to image data indicate the number of whites or blacks, indicating respectively the values (1 or 0) of $2^0$, $2^1$, $2^2$, $2^3$ which together make up the number. $\overline{0}_4$ indicates whether the runlength is for white or black; indicating black when it is 1 and white when it is 0. $\overline{0}_5$ is used for resetting the counter 40 and reading a next character code. When $\overline{0}_5$ is 1 this resets the counter 40 and reads the next character code.

As shown in Figure 7(d), when $A_0$ to $A_6$ are 0011100, the address signals $A_0$ to $A_{10}$ for the ROM 36 become as follows in an initial condition in which the count value of counter 40 is 0:— $A_0$ to $A_6$ are 0011100, $A_7$ to $A_{10}$ are 0000. In this case the ROM output is 010000. (Data is written in the ROM as explained above). It will be apparent from Figure 7(c) that this output corresponds to white 2.

When this is output, the counter increments by +1 and the output $A_7$ to $A_{10}$ becomes 1000. The output $A_0$ to $A_6$ does not change. When accessed $A_0$ to $A_{10}$ of these values the ROM 36 outputs $\overline{0}_0$ to $\overline{0}_5=110010$ as shown in Figure 7(d), and indicates black 3. Similar operations are carried out successively. Finally, $\overline{0}_5$ becomes 1 and the counter 40 is cleared to 0000 and then a next character code is read.

In Figure 6, 14 is a multiplier composed of ROM. This multiplier outputs runlength×N (data being written in the ROM in such a manner as to provide this) in accordance with an address given by the runlength (RL) code output of code convertor 12 and the output N (character enlargement coefficient) of the register 30. In the above example, since runlength codes (from 12) are 01000, 11001, 01000, when these are doubled (N=2) codes 00100, 01101, 00100 are obtained and these are sequentially output. Runlength codes can be multiplied by N easily. The character interval B is set as white 0, namely as 00000. Thereby, it is 0 when it is multiplied by N, making operations for character enlargement easy.

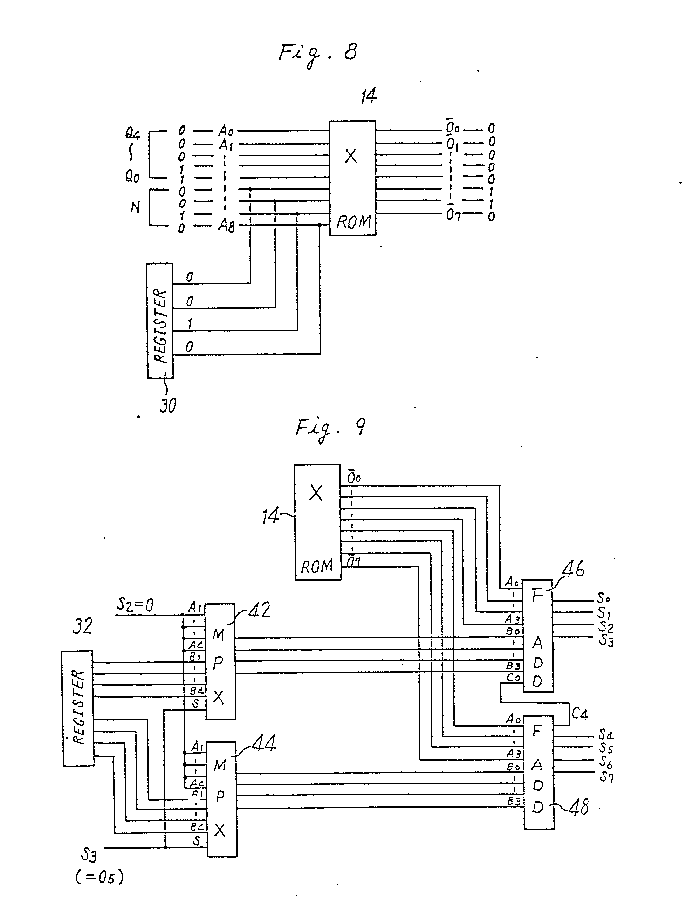

Figure 8 shows as an example, the outputs $\overline{0}_0$ to $\overline{0}_7$ of the multiplier 14 when N=2 and the runlength code for white 3 is input.

In Figure 6, 16 is the character interval insertion circuit comprising adders ADD and multipliers MPX. This circuit has a structure as shown in Figure 9.

In Figure 9, 42, 44 are multiplexers, whilst 46 and 48 are total adders. In the case of any runlength code other than the white 0 runlength code 00000 (which indicates the character interval) a signal $S_3$ is 0 and when the multiplexers 42 and 44 select the signal $S_2$ (which is always 0) they output 0 in response to any such runlength code, ignoring the contents of character interval register 32. The signal $S_2$ becomes 1 when the character interval white 0 runlength code occurs and at such a time the multiplexers 42 and 44 select the register 32 and output the content of the register 32, namely the character interval B (for the enlarged characters) to the total adders 46 and 48. Therefore, the adders 46 and 48 add the output of multiplier 14 (white 0 in this case) and the output B of the multiplexer and then output the results $S_0$ to $S_7$. Thus, the character interval B is provided between characters.

In Figure 6, 18, 20 and 22 are a multiplexer, an adder and a register and operate as runlength code adders. The MPX 18 selects an initial value S (see the remainder mentioned above) sent from MPU and this is set in the register 22. Thereafter, MPX 18 selects the character interval insertion circuit 16 and causes the adder 20 to add the appropriate white or black runlength codes. For example, if the initial value S indicates a white interval, and the first output of the circuit 16 after taking S is white x1, the adder 20 is caused to provide S+x1. In a case in which a character then appears, the runlength code becomes black x2 and addition of white runlengths is terminated. In cases in which continuation is made with one or more whites, such as white in the last part of a preceding character (which is like a character interval), white in a character interval or white in a first part of a next character, all white runlengths are added. When a change appears, for example when black appears next, addition is suspended and the addition result obtained is set in the buffer 24.

The runlength addition effected by adder 20 and register 22 is similar to the runlength addition as explained with reference to Figure 1.

# 0 060 101

Buffer 24 is a fast-in, fast-out (first-in, first-out) type register and it is intended to absorb the runlength calculation time which changes depending upon the image pattern. 26 is a circuit which converts runlength code into one-dimensional coding code. In this embodiment of the present invention circuit 26 is composed of ROM and stores in advance data and numbers of bits of primarily compressed code corresponding to runlength code, and in operation outputs corresponding primarily compressed code. Examples of the code conversion carried out by the conversion circuit 26 are shown in Table 2 and Table 3.

TABLE 2
(Terminating code)

| White runlength | Code | Black runlength | Code |
|---|---|---|---|
| 0 | 001110101 | 0 | 0000110111 |
| 1 | 000111 | 1 | 010 |
| 2 | 0111 | 2 | 11 |
| 3 | 1000 | 3 | 10 |
| 4 | 1011 | 4 | 011 |
| . | | . | |
| . | | . | |
| . | | . | |
| . | | . | |
| . | | . | |
| 62 | 00110011 | 62 | 000001100110 |
| 63 | 00110100 | 63 | 000001100111 |

TABLE 3
(Make up code)

| White runlength | Code | Black runlength | Code |
|---|---|---|---|
| 64 | 11011 | 64 | 0000001111 |
| 128 | 10010 | 128 | 000011001000 |
| 196 | 010111 | 192 | 000011001001 |
| 256 | 0110111 | 256 | 000001011011 |
| . | | . | |
| . | | . | |
| . | | . | |
| . | | . | |
| . | | . | |

In the runlength code sent from the buffer 24, white and black runlengths appear alternately and these are converted to codes as indicated in Table 2 and Table 3 by the circuit 26. Runlengths in the range 0 to 63 are coded in terms only of terminating codes (Table 2). For runlengths of 64 or more make-up codes (Table 3) which indicate a runlength equal to or shorter than the actual runlength are first used and thereafter remaining runlength is indicated by a terminating code. An output of the converter circuit 26 is transmitted to a remote facsimile receiver via a modem and transmission line.

7

# 0 060 101

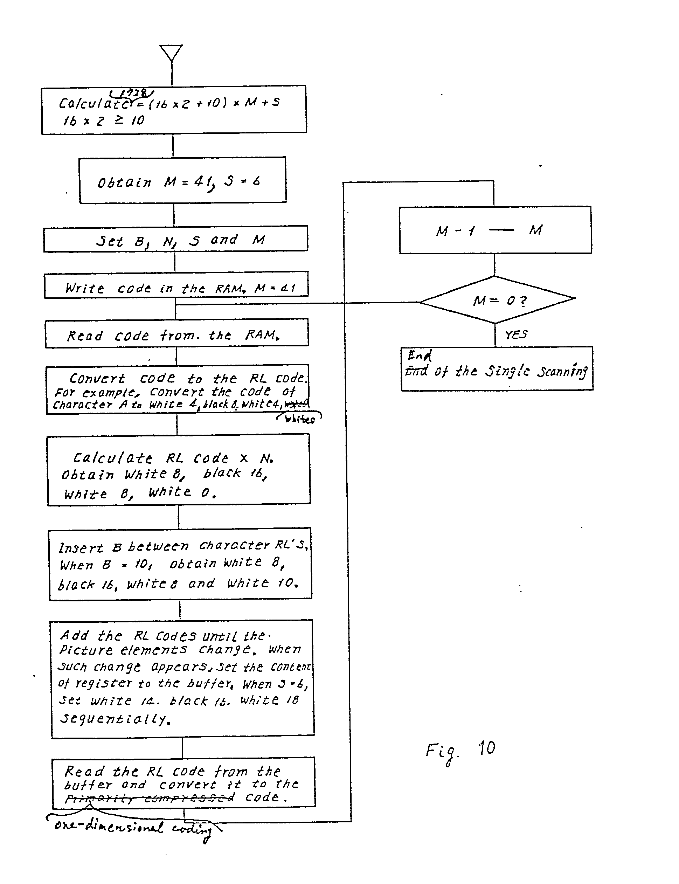

Operations of the apparatus as explained above are summarised in Figure 10. In Figure 10, A is 16, N is 2 and B is 10. In this example, the MPU first effects calculation in accordance with the equation $1728=(16\times2+10)\times M+S$, $16N\geq B$, and outputs M=41, S=6. These parameters B, N, S and M are set in the registers 32, 30, 22 and counter 28. Thereafter, processings as indicated in Figure 10, such as entry of character code into RAM 10, are carried out.

It will be apparent from Figures 6 to 10 that the method illustrated in Figures 1 to 4 is utilised. Namely, the ROM 36 shown in Figure 7 corresponds to the conversion table 111 shown in Figure 1, whilst the counter 40 shown in Figure 7 corresponds to the counter 113 shown in Figure 1, the adder 20 shown in Figure 6 corresponds to the adder 112 shown in Figure 1 and the register 22 shown in Figure 6 corresponds to the register 116 shown in Figure 1.

The embodiment illustrated with reference to Figure 6 to 10 realises effective and simultaneous runlength conversion operations, character enlargement and character interval inserting operations by providing multiplier 14, character interval inserting circuit 16 and multiplexer 18 between the conversion table 111 and adder 112 shown in Figure 1.

Figure 11 is a block diagram of facsimile communication equipment employing character code/ character pattern conversion apparatus as explained with reference to Figures 6 to 10.

In Figure 11, 60 is facsimile communication equipment; 61 is a microprocessor unit; 62 is a host interface controller; 63 is a RAM; 64 is a ROM; 65 is a timer; 66 is a character code/character pattern compression conversion; 67 is a high-level data link controller; 68 is a low speed modem; 69 is a high speed modem; 70 is a line interface; 71 is a GS (group 2) option.

In Figure 11, the character code/character pattern compression converter 66 corresponds to the circuit of Figure 6.

## Claims

1. A method of data conversion, comprising:

reading, from a runlength conversion table (111; 36), successive runlength codes corresponding to a data signal;

and characterised by

holding a last runlength code, or an added runlength code as explained below, temporarily in a register (116; 116-1 to 116-3; 22);

detecting (114, 115), as between the last runlength code and a next runlength code, whether those codes relate to runlengths of bits of the same value (1 or 0);

adding (112; 112-1, 112-2; 20) the runlength code held in the register (116; 116-1 to 116-3; 22) to the said next runlength code, and placing the resulting added runlength code in the register (116; 116-1 to 116-3; 22), when it is detected that the last and next codes relate to runlengths of bits of the same value.

2. A method as claimed in claim 1, comprising:

accessing the runlength conversion table (111; 36) on the basis of addresses (14) each including a counting output provided by calculation means (113, 40) controlled in dependence upon an output (15) of the runlength conversion table.

3. A method as claimed in claim 1 or 2, wherein the data to be converted is image data and bit values correspond to black and white image elements.

4. A method as claimed in claim 1, 2 or 3, wherein the data to be converted is split into data signals each of limited length (e.g. 8 bits), which limited length signals are employed for accessing the runlength conversion table.

5. Data conversion apparatus, for carrying out the method of claim 1, comprising:

a runlength conversion table (111; 36), from which successive runlength codes, corresponding to a data signal, are read when the apparatus is in use;

characterised in that the apparatus further comprises

a register (116; 116-1 to 116-3; 22) for temporarily holding a last runlength code or an added runlength code as explained below;

detection means (114, 115) operable to detect, as between the last runlength code and a next runlength code, whether those codes relate to runlengths of bits of the same value (1 or 0); and

addition means (112; 112-1, 112-2; 20) operable to add the runlength code held in the register (116; 116-1 to 116-3; 22) to the said next runlength code, and to place the resulting added runlength code in the register (116; 116-1 to 116-3; 22), when it is detected that the last and next codes relate to runlengths of bits of the same value.

6. Apparatus as claimed in claim 5, comprising:

calculation means (113, 40) operable, in dependence upon an output (15) of the runlength conversion table (111; 36), to provide a counting output for forming a part of an address (14) for accessing the runlength conversion table.

7. Apparatus as claimed in claim 5 or 6, wherein the data to be converted is image data and bit values correspond to black and white image elements.

8. Apparatus as claimed in claim 5 or 6, wherein the data to be converted is split into data signals each

8

of limited length (e.g. 8 bits), which limited length signals are employed for accessing the runlength conversion table.

9. Apparatus as claimed in claim 5 or 6, being character code/character pattern conversion apparatus comprising:

means (12, 34) operable to receive a character code signal and to generate in dependence thereupon a character pattern signal;

means (12; 36), including the said runlength conversion table (36), for converting each successive line of a character pattern signal into runlength codes;

means (14, 30) for multiplying such runlength codes by a selected character enlargement coefficient to provide respective enlarged-character runlength codes; and

character interval insertion means (16; 42, 44, 46, 48) operable to add a selected character interval code to each enlarged-character runlength code, to provide resultant runlength codes which provide the said last and next runlength codes.

10. Apparatus as claimed in claim 9, comprising:

addition means (18, 20) operable to add a selected initial runlength code value (corresponding either to black or white image elements) to such an enlarged-character runlength code, such that the total number of image elements on each line of the image bearing the characters is the same.

**Patentansprüche**

1. Datenkonversionsverfahren, mit

Lesen, aus einer Lauflängenkonversionstabelle (111; 36), von sukzessiven Lauflängencoden, die einem datensignal entsprechen;

und gekennzeichnet durch

temporäres Halten eines letzten Lauflängencodes, oder eines addierten Lauflängencodes wie unten beschrieben, in einem Register (116; 116-1 bis 116-3; 22);

Detektieren (114, 115), zum Beispiel wie zwischen dem letzten Lauflängencode und einem nächsten Lauflängencode, ob jene Code sich auf Lauflängen von Bits desselben Wertes (1 oder 0) beziehen;

Addieren (112; 112-1, 112-2; 20) des Lauflängencodes, der in dem Register (116; 116-1 bis 116-3; 22) gehalten wird, zu dem genannten nächsten Lauflängencode, und Plazieren des resultierenden addierten Lauflängencodes in das Register (116; 116-1 bis 116-3; 22), wenn festgestellt wird, daß der letzte und der nächste Code sich auf Lauflängen von Bits desselben Wertes beziehen.

2. Verfahren nach Anspruch 1, mit:

Zugreifen zu der Lauflängenkonversionstabelle (111; 36) auf der Basis von Adressen (14), die jeweils einen zählenden Ausgang einschließen, der durch Rechnereinrichtungen (113, 40) geliefert wird, die in Abhängigkeit von einem Ausgang (15) von der Lauflängenkonversionstabelle gesteuert werden.

3. Verfahren nach Anspruch 1 oder 2, bei dem die zu konvertierenden Daten Bilddaten- und Bitwerte sind, die schwarzen und weißen Bildelementen entsprechen.

4. Verfahren nach Anspruch 1, 2 oder 3, bei der die zu konvertierenden Daten in Datensignale gespalten werden, jeweils von begrenzter Länge (z.B. 8 Bit), welche längenbegrenzten Signale zum Zugreifen zu der Lauflängenkonversionstabelle verwendet werden.

5. Datenkonversionsvorrichtung, zum Durchführen des Verfahrens nach Anspruch 1, mit:

einer Lauflängenkonversionstabelle (111; 36), von welcher sukzessive Lauflängencode, die einem Datensignal entsprechen, gelesen werden, wenn die Vorrichtung in Betrieb ist;

dadurch gekennzeichnet, daß die Vorrichtung ferner umfaßt:

ein Register (116; 116-1 bis 116-3; 22) zum temporären Halten eines letzten Lauflängencodes oder eines addierten Lauflängencodes wie unten beschrieben;

Detektoreinrichtungen (114, 115), die betreibbar sind, um zwischen dem letzten Lauflängencode und einem nächsten Lauflängencode zu fühlen, ob jene Code sich auf Lauflängenbits desselben Bit (1 oder 0) beziehen, und

Additionseinrichtungen (112; 112-1, 112-2; 20), die betreibbar sind, um den lauflängencode, der in dem Register (116; 116-1 bis 116-3; 22) gehalten wird, zu dem nächsten Lauflängencode zu addieren, und um den resultierenden addierten Lauflängencode in das Register (116; 116-1 bis 116-3; 22) zu plazieren, wenn festgestellt wird, daß der letzte und der nächste Lauflängencode sich auf Lauflängen von Bits desselben Wertes beziehen.

6. Vorrichtung nach Anspruch 5, mit:

Berechnungseinrichtungen (113, 40), die in Abhängigkeit von einem Ausgang (15) von der Lauflängenkonversionstabelle (111; 36) betreibbar sind, um einen zählenden Ausgang zum Bilden eines Teils einer Adresse (14) zum Zugreifen zu der Lauflängenkonversionstabelle zu bilden.

7. Vorrichtung nach Anspruch 5 oder 6, bei der die zu konvertierenden Daten Bilddaten und Bitwerte sind, die schwarzen und weißen Bildelementen entsprechen.

8. Vorrichtung nach Anspruch 5 oder 6, bei der die zu konvertierenden Daten gespalten werden in Datensignale, jeweils von begrenzter Länge (z.B. 8 Bit), welche längenbegrenzten Signale zum Zugreifen zu der Lauflängenkonversionstabelle verwendet werden.

9. Vorrichtung nach Anspruch 5 oder 6, welche eine Zeichencode/Zeichenmuster-Konversionsvorrichtung ist, mit:

Einrichtungen (12, 34), die betreibbar sind, um ein Zeichencodesignal zum empfangen und in Abhängigkeit davon ein Zeichenmustersignal zu erzeugen;

Einrichtungen (12, 36), die die genannte Lauflängenkonversionstabelle (36) einschließen, zum Konvertieren jeder sukzessiven Zeile von einem Zeichenmustersignal in Lauflängencode;

Einrichtungen (14, 30) zum Multiplizieren solcher Lauflängencode mit einem ausgewählten Zeichenvergrößerungskoeffizienten, um entsprechende zeichenvergrößerte Lauflängencode zu erhalten; und

Zeichenintervall-Einfügungseinrichtungen (16; 42, 44, 46, 48), die betreibbar sind, um einen ausgewählten Zeichenintervallcode zu jedem zeichenvergrößerten Lauflängencode zu addieren, um resultierende Lauflängencode zu liefern, welche den letzten und den nächsten Lauflängencode liefern.

10. Vorrichtung nach Anspruch 9, mit:

Additionseinrichtung (18, 20), die betreibbar sind, um einen ausgewählten anfänglichen Lauflängencodewert (der entweder schwarzen oder weißen Bildelementen entspricht) zu solch einem zeichenver-größerten Lauflängencode zu addieren, so daß die gesamte Anzahl von Bildelementen von jeder Zeile des Bildes, welches die Zeichen trägt, dieselbe ist.


**Revendications**

1. Procédé de conversion de données, consistant à:

lire, dans une table de conversion de longueurs de passage (111; 36), des codes de longueurs de passage successifs correspondant à un signal de données;

et caractérisé en ce qu'il consiste à:

maintenir un dernier code de longueur de passage, ou un code de longueur de passage additionné tel qu'expliqué ci-dessous, temporairement dans un registre (116; 116-1 à 116-3; 22);

détecter (114, 115), comme entre le dernier code de longueur de passage et un code de longueur de passage suivant, si ces codes sont relatifs à des longueurs de passage de bits de la même valeur (1 ou 0);

additionner (112; 112-1, 112-2; 20) le code de longueur de passage maintenu dans le registre (116; 116-1 à 116-3; 22) avec le code de longueur de passage suivant, et placer le code de longueur de passage additionné résultant dans le registre (116; 116-1 à 116-3; 22), quand il est détecté que le dernier code et le code suivant sont relatifs à des longueurs de passage de bits de la même valeur.

2. Procédé selon la revendication 1, consistant à:

avoir accès à la table de conversion de longueurs de passage (111; 36) selon des adresses (14) incluant chacune une information de comptage de sortie fournie par un moyen de calcul (113, 40) commandé selon une information de sortie (15) de la table de conversion de longueurs de passage.

3. Procédé selon l'une quelconque des revendications 1 et 2, dans lequel les données à convertir sont des données d'image et les valeurs de bits correspondent à des éléments d'image noirs et blancs.

4. Procédé selon l'une quelconque des revendications 1 à 3, dans lequel les données à convertir sont divisées en signaux de données ayant chacun une longueur limitée (par exemple, 8 bits), ces signaux de longueur limitée étant mis en oeuvre pour avoir accès à la table de conversion de longueurs de passage.

5. Dispositif de conversion de données, pour mettre en oeuvre le procédé de la revendication 1, comprenant:

une table de conversion de longueurs de passage (111; 36), dans laquelle sont lus des codes de longueurs de passage successifs, correspondant à un signal de données, quand le dispositif est en fonctionnement;

caractérisé en ce que le dispositif comprend en outre:

un registre (116; 116-1 à 116-3; 22) pour maintenir temporairement un dernier code de longueur de passage ou un code de longueur de passage additionné tel qu'expliqué dans la suite;

un moyen de détection (114, 115) pouvant être mis en fonctionnement pour détecter, comme entre le dernier code de longueur de passage et un code de longueur de passage suivant, si ces codes sont relatifs à des longueurs de passage de bits de la même valeur (1 ôu 0); et

un moyen d'addition (112; 112-1, 112-2; 20) pouvant être mis en fonctionnement pour additionner le code de longueur de passage maintenu dans le register (116; 116-1 à 116-3; 22) avec le code de longueur de passage suivant, et pour placer le code de longueur de passage additionné résultant dans le register (116; 116-1 à 116-3; 22), quand il est détecté que le dernier code et le code suivant sont relatifs à des longueurs de passage de bits de la même valeur.

6. Dispositif selon la revendication 5, comprenant:

un moyen de calcul (113, 40) pouvant être mis en fonctionnement, selon une information de sortie (15) de la table de conversion de longueurs de passage (111; 36), pour fournir une information de comptage de sortie afin de former une partie d'une adresse (14) pour avoir accès à la table de conversion de longueurs de passage.

7. Dispositif selon l'une quelconque des revendications 5 et 6, dans lequel les données à convertir sont des données d'image et les valeurs de bits correspondent à des éléments d'image noirs et blancs.

8. Dispositif selon l'une quelconque des revendications 5 et 6, dans lequel les données à convertir sont divisées en signaux de données, chacun d'une longueur limitée (par exemple, 8 bits), ces signaux de longueur limitée étant mis en oeuvre pour avoir accès à la table de conversion de longueurs de passage.

9. Dispositif selon l'une quelconque des revendications 5 et 6, qui est un dispositif de conversion de codes de caractères/de modèles de caractères comprenant:

un moyen (12, 34) pouvant être mis en fonctionnement pour recevoir un signal de code de caractère et pour engendrer selon celui-ci un signal de modèle de caractère;

un moyen (12; 36), incluant la table de conversion de longueurs de passage (36), pour convertir chaque ligne successive d'un signal de modèle de caractère en codes de longueurs de passage;

un moyen (14, 30) pour multiplier ces codes de longueurs de passage par un coefficient d'agrandissement de caractère sélectionné afin de fournir des codes de longueurs de passage de caractères agrandis respectifs; et

un moyen d'insertion d'intervalle entre caractères (16; 42, 44, 46, 48) pouvant être mis en fonctionnement pour additionner un code d'intervalle entre caractères sélectionné avec chaque code de longueur de passage de caractère agrandi, afin de fournir des codes de longueurs de passage résultants qui fournissent le dernier code et le code suivant de longueur de passage.

10. Dispositif selon la revendication 9, comprenant:

un moyen d'addition (18, 20) pouvant être mis en fonctionnement pour additionner une valeur de code de longueur de passage initiale sélectionnée (correspondant à des éléments d'image noirs ou blancs) avec ce code de longueur de passage de caractère agrandi, tel que le nombre total d'éléments d'image sur chaque ligne de l'image portant les caractères est le même.

Fig. 1

0 060 101

Fig 2

W : white
B : Black

0 060 101

11

| | Input (13.14) | | | | | | | | | | | Out put (15.16.17) | | | | | | | | | | |
|---|---|---|---|---|---|---|---|---|---|---|---|---|---|---|---|---|---|---|---|---|---|---|
| $t_1$ | 1 0 0 1 1 1 0 0 | 0 0 0 | | | | | | | | | | 1 0 0 0 0 0 0 1 | | | | | | | | B 1 | | |
| $t_2$ | 1 0 0 1 1 1 0 0 | 0 0 1 | | | | | | | | | | 0 0 0 0 0 0 1 0 | | | | | | | | W 2 | | |
| $t_3$ | 1 0 0 1 1 1 0 0 | 0 1 0 | | | | | | | | | | 1 0 0 0 0 0 1 1 | | | | | | | | B 3 | | |
| $t_4$ | 1 0 0 1 1 1 0 0 | 0 1 1 | | | | | | | | | | 0 1 0 0 0 0 1 0 | | | | | | | | W 2 | | |
| $t_5$ | 0 0 0 0 0 0 0 0 | 0 0 0 | | | | | | | | | | 0 1 0 0 1 0 0 0 | | | | | | | | W 8 | | |
| $t_6$ | 1 1 1 0 ———————— | 0 0 0 | | | | | | | | | | 1 0 0 0 0 0 1 1 | | | | | | | | B 3 | | |
| $t_7$ | | 0 0 1 | | | | | | | | | | | | | | | | | | | | |

13   14   17   15   16

B : Black
W : White

Fig. 3

Fig. 4

0 060 101

# Fig. 5

(a)

1728 bits
M = 64
N = 1
S = 0

$A \times N = 16$ — $B = 11$ — $A \times N = 16$

(b)

1728 bits
M = 41
N = 2

$S = 6$ — $A \times N = 32$ — $B = 10$

Fig. 6

Fig. 7

(a)

CHARACTER CODE

POSITION

$A_0$ $A_1$ $A_5$ $A_6$ $A_8$

C G

34

$D_0$ $D_1$ $D_6$

$A_0$ $A_1$ $A_6$ $A_7$ $A_{10}$

R O M

36

$\bar{0}_0$ $\bar{0}_1$ $\bar{0}_2$ $\bar{0}_3$ $\bar{0}_4$ $\bar{0}_5$

$S_1$ → COUNTER 38

40

COUNTER

(b)

$A_8$ $A_7$ $A_6$    $D_0 D_1 D_2 D_3 D_4 D_5 D_6$    $A_5 A_4 A_3$

```
0 0 0          0 0 0
0 0 1
0 1 1          0 1 0
0 0 1          1 0 1
0 1 1          0 1 0
1 1 1          0 0 1
1 1 0          0 1 0
```

$A_2$   0
$A_1$   0
$A_0$   1

(C)

| $\bar{0}_0$ | $\bar{0}_1$ | $\bar{0}_2$ | $\bar{0}_3$ | $\bar{0}_4$ | $\bar{0}_5$ |
|---|---|---|---|---|---|
| $2^0$ | $2^1$ | $2^2$ | $2^3$ | DECISION OF BLACK/WHITE | RESET 40 |

(d)

| $A_0$ | $A_1$ | $A_2$ | $A_3$ | $A_4$ | $A_5$ | $A_6$ |
|---|---|---|---|---|---|---|
| 0 | 0 | 1 | 1 | 1 | 0 | 0 |

⇓

| $A_{10}$ | $A_9$ | $A_8$ | $A_7$ | $\bar{0}_0$ | $\bar{0}_1$ | $\bar{0}_2$ | $\bar{0}_3$ | $\bar{0}_4$ | $\bar{0}_5$ |
|---|---|---|---|---|---|---|---|---|---|
| 0 | 0 | 0 | 0 | 0 | 1 | 0 | 0 | 0 | 0 |
| 0 | 0 | 0 | 1 | 1 | 1 | 0 | 0 | 1 | 0 |
| 0 | 0 | 1 | 0 | 0 | 1 | 0 | 0 | 0 | 0 |
| 0 | 0 | 1 | 1 | 0 | 0 | 0 | 0 | 0 | 1 |

RUN LENGTH CODE

| CG OUTPUT | 0 0 | 1 1 1 | 0 0 | B |
|---|---|---|---|---|
| RUN LENGTH | WHITE 2 | BLACK 3 | WHITE 2 | WHITE 0 |
| 40 OUTPUT | 0 | 1 | 2 | 3 |

Fig. 8

Fig. 9

Calculate (1728) = (16 x Z + 10) x M + S
16 x Z ≥ 10

Obtain M = 41, S = 6

Set B, N, S and M

Write code in the RAM, M = 41

Read code from the RAM,

Convert code to the RL code.
For example, Convert the code of
Character A to White 4, black 8, White 4, white 4
(whites)

Calculate RL code x N,
Obtain White 8, black 16,
White 8, White 0.

Insert B between character RL'S,
When B = 10, obtain white 8,
black 16, white 8 and White 10.

Add the RL Codes until the
Picture elements change, When
such change appears, Set the content
of register to the buffer, When S = 6,
Set white 14. black 16. White 18
Sequentially,

Read the RL code from the
buffer and convert it to the
Primarily compressed code.

one-dimensional coding

M - 1 ── M

M = 0 ?

YES

End
End of the Single Scanning

Fig. 10

9

## Fig. 11

FROM/TO HOST COMPUTER SYSTEM

- **62** HOST INTERFACE CONTROLLER
- **61** M P U MICRO PROCESSOR
- **67** HIGH LEVEL DATA LINK CONTROLLER
- **68** LOW SPEED MODEM
- **69** HIGH SPEED MODEM
- **70** LINE INTERFACE CIRCUIT
- **63** R A M
- **64** R O M
- **65** TIMER
- **66** C G & COMPRESSION
- **71** G2 OPTION
- **60**

FROM/TO NCU (NETWORK CONTROL UNIT)

0 060 101